# EUROPEAN PATENT SPECIFICATION

(11) **EP 2 048 777 B1**
(45) Date of publication and mention of the grant of the patent: **15.04.2015**
(21) Application number: 07790774.9
(22) Date of filing: 13.07.2007
(51) Int. Cl.: H03H 7/01, H01F 17/00, H01F 27/00, H01G 4/40

(54) **Noise filter array**
Rauschfilter-Array
Réseau de filtres anti-bruit

(30) Priority: 27.07.2006 JP 2006205291
(43) Date of publication of application: 15.04.2009
(73) Proprietor: Murata Manufacturing Co. Ltd., Nagaokakyo-shi, Kyoto 617-8555 (JP)
(72) Inventor: HADANO, Kenjiro, Nagaokakyo-shi, Kyoto 6178555 (JP); SASAKI, Tomohiro, Nagaokakyo-shi, Kyoto 6178555 (JP); UENO, Haruhiko, Nagaokakyo-shi, Kyoto 6178555 (JP)
(74) Representative: Zimmermann, Tankred Klaus
(86) International application number: PCT/JP2007/063994
(87) International publication number: WO 2008/013073

(56) References cited:
- WO-A-98/45921
- DE-A1- 3 545 405
- DE-A1- 4 032 707
- GB-A- 2 198 605
- JP-A- 2004 343 696
- JP-A- 2005 064 267
- JP-U- 07 010 914
- US-B1- 6 456 481

## Description

### Technical Field

The present invention relates to a noise filter array in which a plurality of filter elements formed of an LC parallel resonant circuit and an LC series resonant circuit, each of which has a coil and a capacitor, are arranged in an array and integrally formed.

### Background Art

For example, various communication modes (GSM mode, DCS mode, PCS mode, and the like) are used for cellular phones. Then, in order to prevent degradation in receiving sensitivity in respective communication bands used for these communication modes, it is necessary to effectively remove noise in each of the communication bands.

For example, to remove noise in respective communication bands around 900 MHz and around 1.8 GHz, a noise filter is required to obtain attenuation over a wide band range. To form a filter having such a wide-range attenuation characteristic, it is conceivable that an inductance is given to a grounded capacitor to form a double-resonance filter.

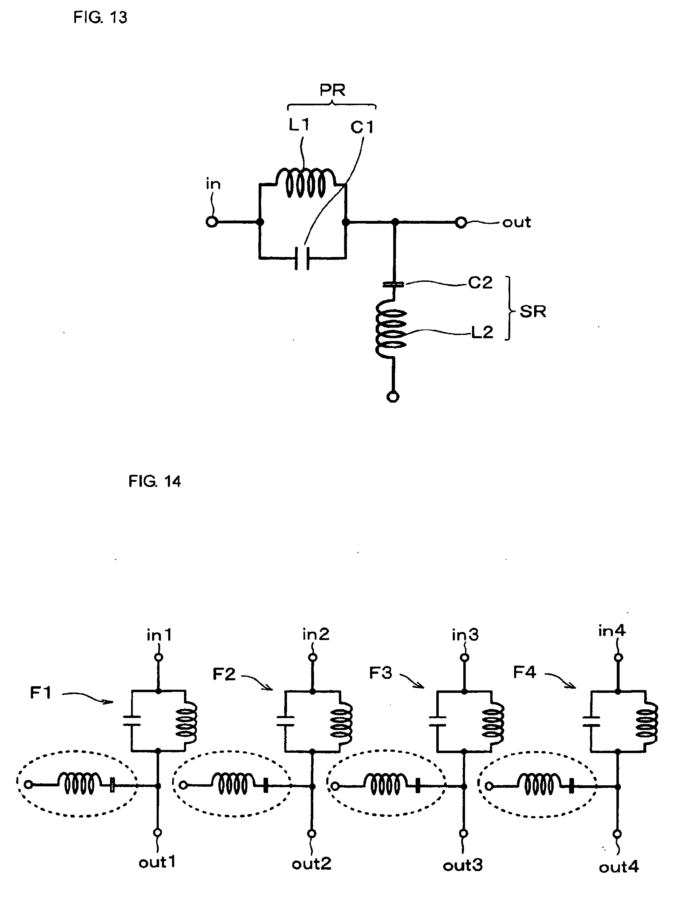

Then, in the existing art, as shown in FIG. 13, it has been suggested a double-resonance filter element that includes an LC parallel resonant circuit PR formed so that a stray capacitance C1 is formed in parallel with a coil L1 provided in a signal line and an LC series resonant circuit SR formed so that a capacitor C2 and a coil L2 are connected in series between the signal line and a ground (for example, see JP 09-266430 A).

When a noise filter array is formed so that a plurality of the above existing double-resonance filter elements are arranged, and these filter elements are formed integrally with one another, an array structure will be, for example, has an equivalent circuit as shown in FIG. 14. Note that here, the case in which four filter elements are provided is shown as an example.

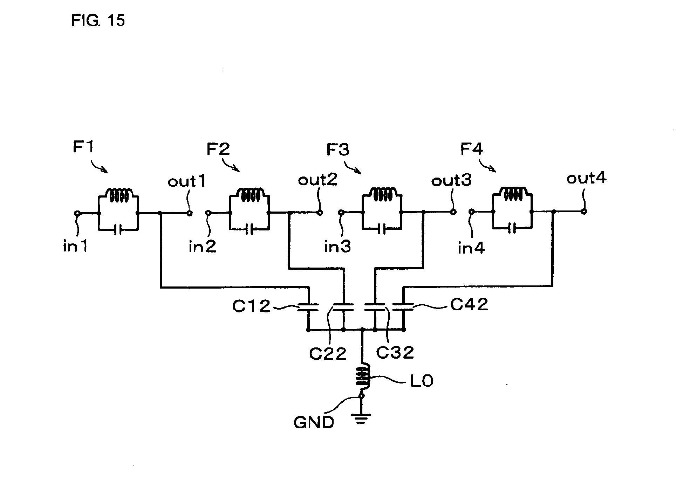

In the array structure shown in FIG. 14, any LC series resonant circuit portions surrounded by the broken lines in the drawing are grounded. Thus, in order to further simplify the structure, it is conceivable that coils included in the respective LC series resonant circuits are integrated. Then, in this case, for example, the structure will be as shown in FIG. 15.

That is, in the noise filter array shown in FIG. 15, signal-side electrodes of capacitors c12 to C42 that constitute the LC series resonant circuits of the respective filter elements are provided separately for the respective filter elements, while a conductor L0 that serves as an inductance coil is commonly connected to ground-side electrodes of these capacitors C12 to C42. Thus, the structure is simplified.

The noise filter array having the structure shown in FIG. 15 can simplify the structure overall; however, distances from the capacitors C12 to C42 of the filter elements F1 to F4 via the conductor L0 to a ground terminal GND are different among each other (for example, the distance from the capacitor C12 to the ground terminal GND is different from the distance from the capacitor C22 to the ground terminal GND). Thus, an inductance value varies among the filter elements F1 to F4 and, as a result, variations in filter characteristic problematically arise among the filter elements F1 to F4.

DE 40 32 707 A1 describes an anti-interference filter for radio-shielding a feeder to a gradient coil in a nuclear magnetic resonance imaging apparatus. The filter is constructed as a band elimination (band rejection) filter for the operating frequency of the nuclear magnetic resonance imaging apparatus. The anti-interference filter can be in the form of a directionally symmetrical quadrupole having two input terminals and two output terminals. A first input terminal and a first output terminal are introducible into the feeder to the gradient coil, and a second input terminal and a second output terminal are connected to a conductor at reference potential. A number of blocking circuits are arranged in series between the first input terminal and the first output terminal. A number acceptor circuits are arranged between the input terminals, between the junctions of the blocking circuits and the reference potential conductor, and between the output terminals. The number of acceptor circuits is one more than the number of blocking circuits.

### Summary of Invention

It is an object of the invention to provide a noise filter array that has a simple structure overall and that eliminates variations in characteristic among a plurality of filter elements.

This object is achieved by a noise filter array of claim 1 or 2.

### Advantages

According to the invention of Claim 1 of the present application, it is possible to easily implement a noise filter array that is formed so that a plurality of LC parallel resonant circuits and LC series resonant circuits, each of which has a coil and a capacitor, are integrally formed, without requiring any specifically complex configuration. In addition, each filter element is formed of an LC parallel resonant circuit and an LC series resonant circuit, and the LC series resonant circuit is formed of a grounding capacitor and an inductance adjusting conductor. Thus, it is possible to easily form a noise filter array that includes a plurality of double-resonance filter elements. Furthermore, a ground-side electrode of the grounding capacitors that constitute the filter elements arranged parallel to one another is connected to the inductance adjusting conductor through a via hole, and the length of the inductance adjusting conductor from a connection position with the via hole to a ground terminal is equal among the filter elements. Thus, variations in inductance value among the filter elements may be reduced.

In the case of the invention according to Claim 2, two filter elements are provided on each side of the inductance adjusting conductor in its laminated direction. Thus, it is possible to reduce the magnetic influence between the filter elements provided on both sides of the inductance adjusting conductor, and it is possible to substantially equalize magnetic flux distributions that arise in the coils of the filter elements that are arranged parallel and adjacent to each other. Thus, variations in inductance value among the filter elements may be further reduced. In addition, a noise filter array that includes four filter elements may be efficiently formed.

According to the noise filter array of Claim 3, the inductance adjusting conductor is a conductor having a meander shape or a linear shape and is formed symmetrically with respect to a point or symmetrically with respect to a line. Thus, not only it is effective to reduce variations in inductance value among the filter elements but also, when an inductance adjusting conductor is formed by plating, it is possible to suppress variations in plating thickness to a lesser degree at the time of forming the conductor. Hence, it is possible to reduce costs.

In addition, as in the case of the noise filter array according to Claim 4, when a connection point, at which the inductance adjusting conductor is connected to the via hole, is located at the center position with respect to which each ground terminal is point-symmetric or line-symmetric, not only it is effective to reduce variations in inductance value among the filter elements but also only one via hole is required. Thus, it is possible to reduce costs, and it is possible to easily adjust a resonance frequency.

In addition, a plurality of via holes may be formed where necessary. In this case as well, by employing the configuration of the noise filter array according to the invention of Claim 5, it is possible to reduce variations in inductance value among the filter elements.

In addition, as in the case of the noise filter array according to Claim 6, when the plurality of filter elements are provided only on one side of the inductance adjusting conductor in its laminated direction, it is possible to reduce the thickness of the component to achieve a reduction in size.

In addition, as in the case of the noise filter array according to Claim 7, when the four filter elements are arranged parallel to one another, it is possible to form a noise filter array that includes four filter elements.

In addition, in the noise filter array according to Claim 8, conductors for forming the coils that constitute the LC parallel resonant circuits and the LC series resonant circuits are formed at positions that do not overlap one another in their thickness direction. Thus, the thickness of the component in the thickness direction is made uniform and, as a result, stress at the time of manufacturing is reduced. Hence, it is possible to suppress and prevent occurrence of crack between conductors for forming the coils of the adjacent layers. This can improve yields of the product.

In addition, in the noise filter array according to Claim 9, a further inductance adjusting conductor is also arranged on the side of the signal-side electrode of the grounding capacitor of each of the LC series resonant circuits. Thus, it is possible to set a large inductance value for the series resonant circuit of each filter element and, therefore, it is possible to gain a further low frequency in each resonant circuit. In addition, the inductance values of the individual filter elements may be set separately.

### Brief Description of Drawings

FIG. 1 is an external perspective view of a noise filter array according to a first embodiment of the invention.
FIG. 2 is an exploded perspective view of the noise filter array according to the first embodiment of the invention.
FIG. 3 is an electrical equivalent circuit diagram of the noise filter array according to the first embodiment of the invention.
FIG. 4 is an electrical equivalent circuit diagram that shows the rearranged electrical equivalent circuit diagram of FIG. 3 so as to correspond to the exploded perspective view of FIG. 2.
FIG. 5 is a characteristic chart that shows examples of measured results of insertion loss characteristics when an inductance adjusting conductor is inserted and when no inductance adjusting conductor is inserted, with respect to the noise filter array having the structure according to the first embodiment.
FIG. 6 is a characteristic chart that shows the measured results of an insertion loss characteristic of each filter element, with an inductance adjusting conductor provided, with respect to the noise filter array having the structure according to the first embodiment.
FIG. 7 is an exploded perspective view of a noise filter array according to a second embodiment of the invention.
FIG. 8 is an exploded perspective view of a noise filter array according to an example not covered by the invention.
FIG. 9 is an exploded perspective view of a noise filter array according to a third embodiment of the invention.
FIG. 10 is an exploded perspective view of a noise filter array according to a fourth embodiment of the invention.
FIG. 11 is an exploded perspective view of a noise filter array according to a fifth embodiment of the invention.
FIG. 12 is an exploded perspective view of a noise filter array according to a sixth embodiment of the invention.
FIG. 13 is an electrical equivalent circuit diagram of an existing double-resonance filter element formed of an LC parallel resonant circuit and an LC series resonant circuit.
FIG. 14 is an electrical equivalent circuit diagram that shows an example in which existing four double-resonance filter elements are arranged in an array.
FIG. 15 is an electrical equivalent circuit diagram that shows a noise filter array that is obtained when coils are integrated in order to simplify the structure shown in FIG. 14.

### Reference Numerals

- in1 to in4: input terminal
- out1 to out4: output terminal
- GND, GND1, GND2: ground terminal
- F1 to F4: filter element
- PR1 to PR4: LC parallel resonant circuit
- L11 to L41: coil
- C11 to C41: stray capacitor
- L0: inductance adjusting conductor
- L01 to L03: inductance adjusting conductor
- L12 to L42: inductance adjusting conductor
- C12 to C42: capacitor
- 1: laminated body
- 2: external electrode
- 3: direction identification mark
- 5: coil conductor
- 6: insulating sheet
- 7: via hole
- 8: signal-side electrode
- 9: ground-side electrode

### Best Modes for Carrying Out the Invention

Hereinafter, embodiments of the invention will be described in greater detail.

### First Embodiment

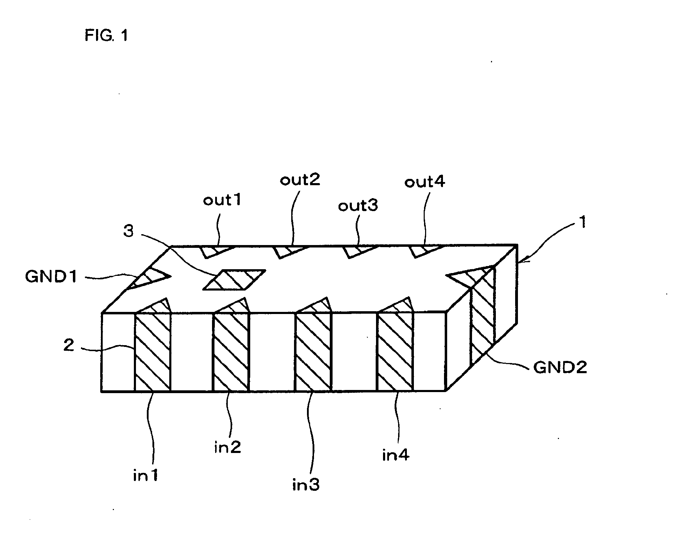

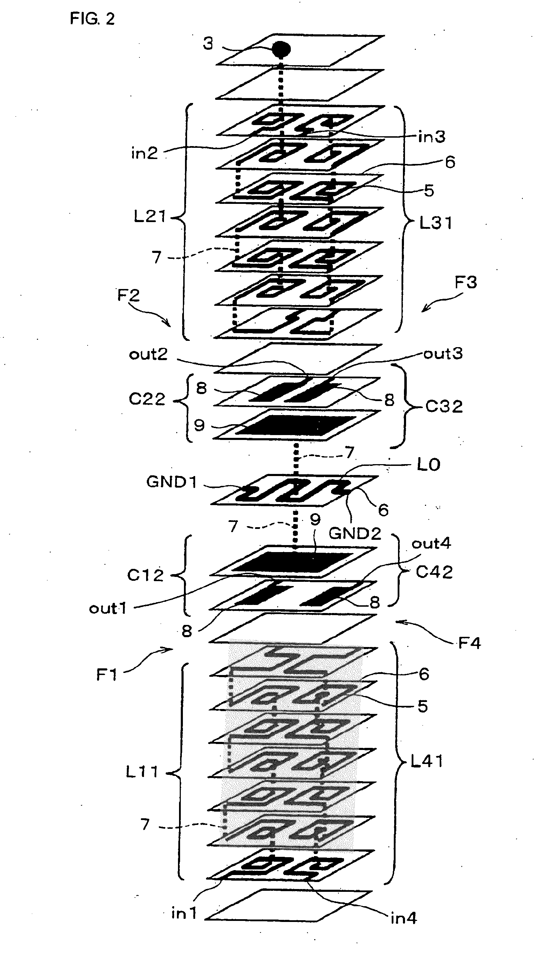

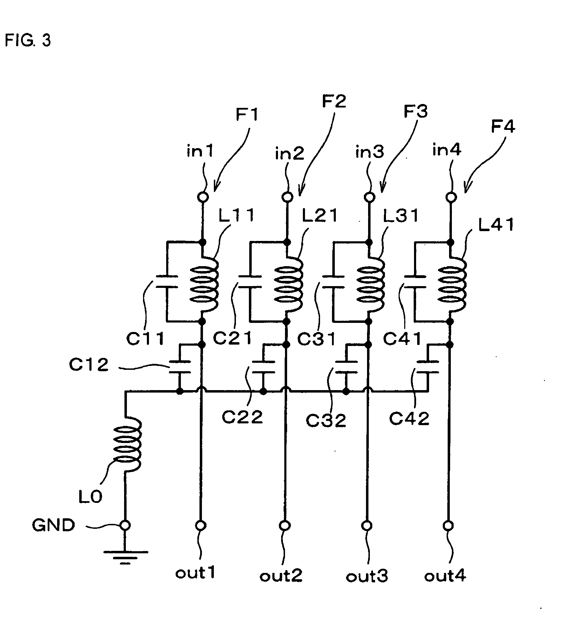

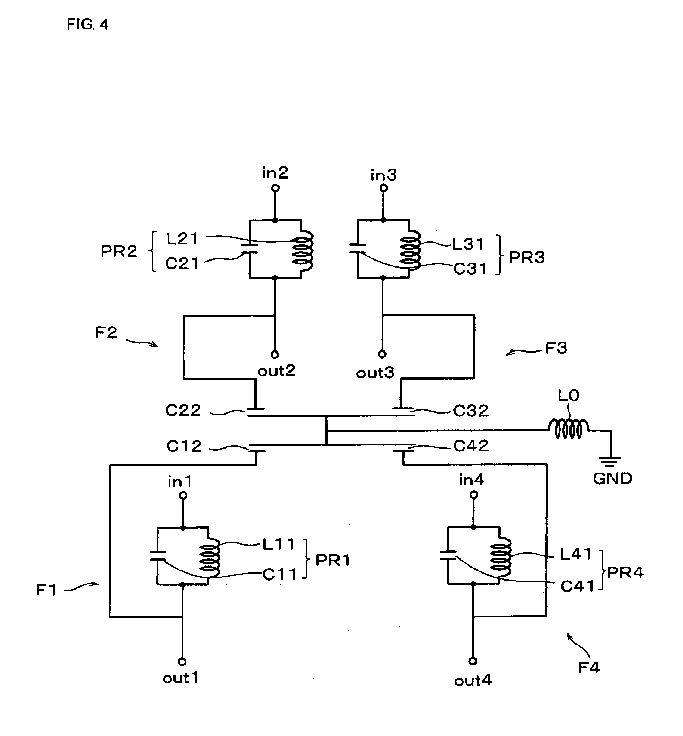

FIG. 1 is an external perspective view of a noise filter array according to a first embodiment of the invention. FIG. 2 is an exploded perspective view of the noise filter array. FIG. 3 is an electrical equivalent circuit diagram of the noise filter array. FIG. 4 is an electrical equivalent circuit diagram that shows the rearranged electrical equivalent circuit diagram of FIG. 3 so as to correspond to the exploded perspective view of FIG. 2. Hereinafter, the noise filter array according to the first embodiment will be described with reference to FIG. 1 to FIG. 4.

The noise filter array of the first embodiment has a rectangular-parallelepiped-shaped laminated body 1. The laminated body 1 is formed in such a manner that rectangular insulating sheets made of a ceramic dielectric material such as barium titanate or a ceramic magnetic material such as ferrite are laminated and integrally fired. Then, external electrodes 2 for forming terminals are formed on the peripheral sides of the laminated body 1. The external electrodes 2 arranged on the front and rear side faces of the long sides are formed as signal input terminals in1 to in4 and signal output terminals out1 to out4. In addition, the external electrodes 2 arranged on the right and left side faces of the short sides are formed as ground terminals GND1 and GND2. Furthermore, a direction identification mark 3 is formed on the upper face of the laminated body 1 at a position slightly deviated from the center.

In addition, four double-resonance filter elements F1 to F4 are integrally formed in the laminated body 1 in correspondence with the above four input terminals in1 to in4 and the output terminals out1 to out4. Note that the filter elements F1 to F4 are arranged respectively on both sides two by two across an inductance adjusting conductor L0, which will be described later, in the thickness direction of the component (laminated direction). That is, two filter elements F2 and F3 are arranged parallel to each other in a direction perpendicular to the thickness direction above the inductance adjusting conductor L0, and two filter elements F1 and F4 are arranged parallel to each other in a direction perpendicular to the thickness direction below the inductance adjusting conductor L0.

The filter elements F1 to F4 respectively include LC parallel resonant circuits PR1 to PR4, grounding capacitors C12 to C42, and the single inductance adjusting conductor L0 that serves as an inductance coil (FIG. 4). Then, LC series resonant circuits of the filter elements F1 to F4 are respectively formed of the grounding capacitors C12 to C42 and the single inductance adjusting conductor L0 common to the capacitors C12 to C42.

As shown in FIG. 2, the LC parallel resonant circuits PR1 to PR4 are formed of coils L11 to L41 and stray capacitors C11 to C41, respectively. Each of the coils L11 to L41 is formed into a spiral shape so that a plurality of insulating sheets 6 in which a spiral coil conductor 5 is formed are laminated and the coil conductors 5 in the respective layers are electrically connected through via holes 7. The stray capacitors C11 to C41 are formed due to stray capacitances that inevitably arise in association with formation of the coils. Then, one ends of the coil conductors 5 that form the coils L11 to L41 are respectively connected to the external electrodes 2 that respectively form the input terminals in1 to in4, and the other ends are respectively connected to the external electrodes 2 that respectively form the output terminals out1 to out4 of the laminated body 1.

Note that the coil conductors 5 of the LC parallel resonant circuits PR1 to PR4 for forming the coils L11 to L41 are formed in shifted positions so as not to overlap one another in the thickness direction. By so doing, the thickness of the laminated body 1 in the thickness direction is made uniform and, as a result, internal stress at the time of manufacturing the laminated body 1 is reduced. Thus, it is possible to suppress occurrence of crack between the coil conductors 5 of the adjacent layers. This can improve yields of the product.

On the other hand, the grounding capacitors C12 to C42 that constitute the LC series resonant circuits are formed in such a manner that the signal-side electrode 8 formed on the insulating sheet 6 is arranged to face the ground-side electrode 9 via that insulating sheet 6. The signal-side electrodes 8 are provided separately in correspondence with the parallel resonant circuits PR1 to PR4, whereas the ground-side electrodes 9 each are arranged to face the pair of parallel arranged signal-side electrodes 8 in common.

Then, one ends of the signal-side electrodes 8 are extended to one end on the rear side of the insulating sheets 6 and are respectively connected to the external electrodes 2 that form the output terminals out1 to out4. In addition, the ground-side electrodes 9 are electrically connected to the inductance adjusting conductor L0 through the via holes 7.

In addition, the inductance adjusting conductor L0 has a meander shape and is formed symmetrically with respect to a point. Then, the inductance adjusting conductor L0 is extended to the left and right ends of the insulating sheet 6, and is connected to the external electrodes 2 that respectively form the ground terminals GND1 and GND2. Note that the noise filter array of the first embodiment is formed so that the lengths of the inductance adjusting conductor L0 from the position connected to the via holes 7 to the ground terminals GND1 and GND2 are equal among the filter elements F1 to F4. That is, in the first embodiment, the connection points of the inductance adjusting conductor L0 with the via holes 7 are located at a center position with respect to which the ground terminals GND1 and GND2 are point-symmetric.

In this way, in the first embodiment, the ground-side electrode 9 is common to the capacitors C22 and C32 that are arranged parallel to each other, the ground-side electrode 9 is common to the capacitors C12 and C42 that are arranged parallel to each other. Those common ground-side electrodes 9 both are connected to the inductance adjusting conductor L0 through the respective via holes 7, and the connection points are located at the center position with respect to which the ground terminals GND1 and GND2 are point-symmetric. Thus, the distances from the capacitors C22 and C32 of the elements F2 and F3 that are arranged parallel to each other to the ground terminals GND1 and GND2 and the distances from the capacitors C12 and C42 of the elements F1 and F4 that are arranged parallel to each other to the ground terminals GND1 and GND2 all are equal. Thus, variations in inductance value among the filter elements F1 to F4 are reduced.

Note that in order to obtain a desired inductance value, the shape of the inductance adjusting conductor L0 may be formed symmetrically with respect to a line other than the above described point symmetry. In addition, by forming the shape of the inductance adjusting conductor L0 into the above symmetric form, variations in plating thickness at the time of forming the conductor L0 may be reduced. In terms of this point as well, it is advantageous.

Note that the direction identification mark 3 allows the fitting direction of the noise filter array to be identified, and is electrically connected to the coil conductor 5 through the via hole 7. Note that the reason why the direction identification mark 3 is electrically connected to the coil conductor 5 is to ensure plating adhesion of the direction identification mark 3.

To manufacture the above configured noise filter array, a conductive paste containing Ag, Pd, Cu or Au, or an alloy of them, or the like, as a conductive component is, for example, applied on the insulating sheets 6 through a method, such as screen printing, to thereby form the coil conductors 5, the signal-side electrodes 8 and ground-side electrodes 9 of the capacitors C12 to C42, the inductance adjusting conductor L0 and the direction identification mark 3. In addition, the via holes 7 are formed in such a manner that through-holes for via holes are formed using a laser beam and these through-holes are filled with a conductive paste containing a conductive component, such as Ag, Pd, Cu or Au, or an alloy of them, or the like. Then, as shown in FIG. 2, conductors, electrodes, via holes, and the like, are formed on the insulating sheets 6. The insulating sheets 6 are laminated and then pressure-bonded to thereby obtain the laminated body 1. Subsequently, the external electrodes 2, which serve as the input terminals in1 to in4, the output terminals out1 to out4 and the ground terminals GND1 and GND2, are formed on the side faces of the laminated body 1, and then the laminated body 1 is fired. Then, Ni plating or Sn plating is performed on the surface of each external electrode 2. By so doing, the rectangular-parallelepiped-shaped noise filter array having the structure as shown in FIG. 1 may be obtained.

As described above, in the noise filter array of the first embodiment, the double-resonance filter elements F1 to F4 include the common single inductance adjusting conductor L0. Thus, at the time of manufacturing the noise filter array, by changing the shape of the conductor L0, it is possible to easily adjust the series resonant (secondary resonance) frequency owing to the capacitors C12 to C42 and the inductance adjusting conductor L0.

Then, in the noise filter array of the first embodiment, the distances from the ground-side electrodes 9 of the capacitors C22 and C32 and the capacitors C12 and C42 that constitute the LC series resonant circuits to the ground terminals GND1 and GND2 through the via holes 7 and the inductance adjusting conductor L0 all are equal among the filter elements F1 to F4. Thus, variations in inductance value among the filter elements F1 to F4 are reduced.

In addition, in the noise filter array of the first embodiment, two filter elements F2 and F3 and two filter elements F1 and F4 are separately arranged respectively on both sides of the ground-side electrodes 9 of the capacitors C12 to C42 in the thickness direction (laminated direction). Thus, it is possible to reduce the magnetic influence between the filter elements F2 and F3 and between the filter elements F1 and F4 on both sides thereof, and it is possible to substantially equalize magnetic flux distributions that arise in the coils of the filter elements F2 and F3 that are arranged parallel and adjacent to each other and in the coils of the filter elements F1 and F4 that are arranged parallel and adjacent to each other. By so doing, variations in inductance value among the filter elements F1 to F4 may be further reduced.

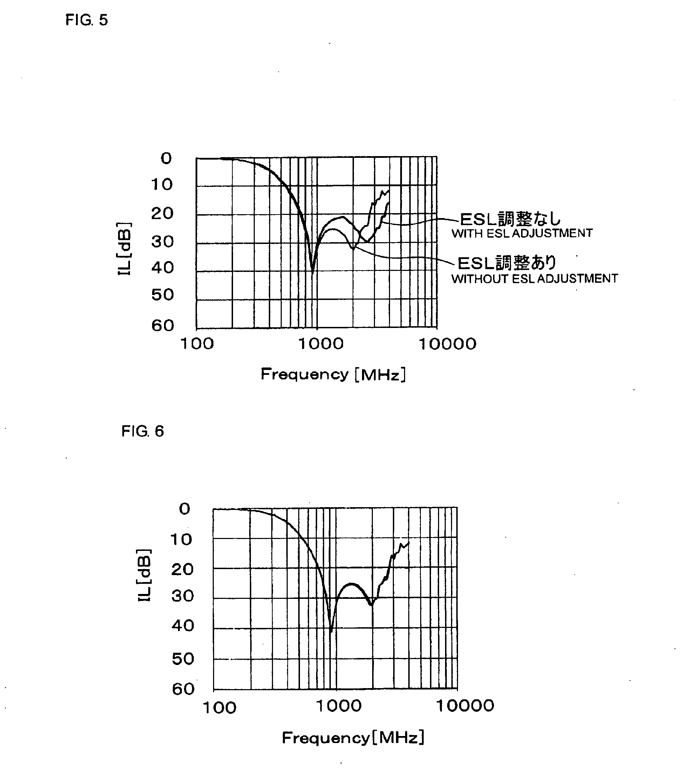

FIG. 5 is a characteristic chart that shows examples of measured results of insertion loss characteristics when the inductance adjusting conductor L0 is inserted and when no inductance adjusting conductor L0 is inserted.

As shown in FIG. 5, it may be understood that by inserting the inductance adjusting conductor L0, the series resonant (secondary resonant) frequency of each of the filter elements F1 to F4 can be adjusted to a desired frequency (in this example, 2 GHz).

FIG. 6 is a characteristic chart that shows the measured results of an insertion loss characteristic of each of the filter elements F1 to F4, with the inductance adjusting conductor L0 provided, in the noise filter array having the structure according to the first embodiment.

From FIG. 6, it appears that by providing the inductance adjusting conductor L0, insertion loss characteristics of the filter elements F1 to F4 are substantially equal, and the characteristics of the filter elements F1 to F4 overlap one another and represented as one solid line. By so doing, it may be understood that there is no difference in characteristic of series resonant (secondary resonant) frequency among the filter elements.

### Second Embodiment

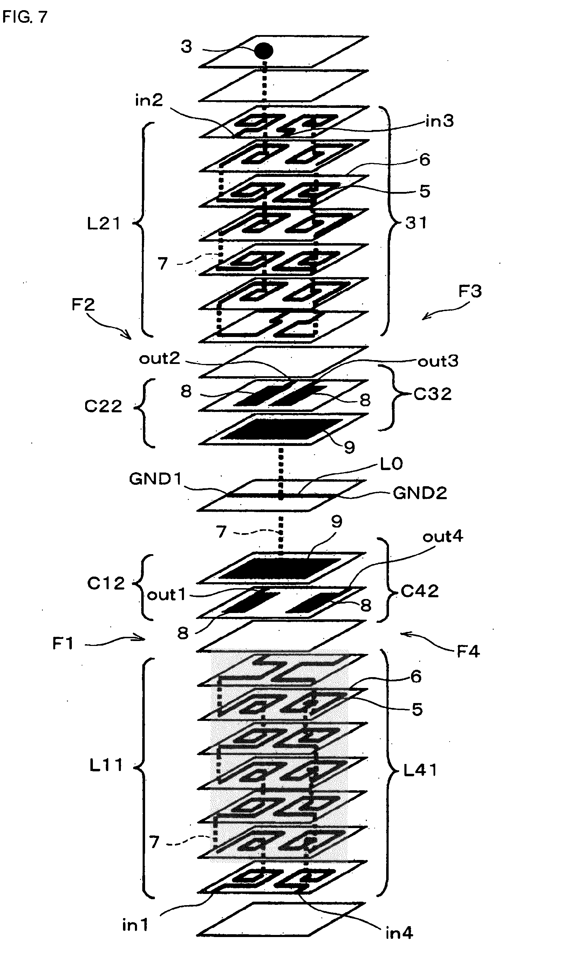

FIG. 7 is an exploded perspective view of a noise filter array according to a second embodiment of the invention. Note that in FIG. 7, portions assigned with the same reference signs as those in FIG. 1 to FIG. 4 are portions similar to or corresponding to the configuration of the first embodiment.

The noise filter array according to the second embodiment has such a feature that the inductance adjusting conductor L0 placed between the capacitors C12 to C42 that constitute the LC series resonant circuits of the filter elements F1 to F4 is formed linearly.

Even in the case of the noise filter array of the second embodiment, the distances from the ground-side electrodes 9 of the capacitors C22 and C32 and the capacitors C12 and C42 that constitute the LC series resonant circuits to the ground terminals GND1 and GND2 through the via holes 7 and the inductance adjusting conductor L0 all are equal among the filter elements F1 to F4. Thus, variations in inductance value among the filter elements F1 to F4 are reduced. The other configuration, function and advantageous effects are similar to those of the first embodiment shown in FIG. 1 to FIG. 4, so detailed description thereof is omitted to avoid overlaps.

### Example (not covered by the invention)

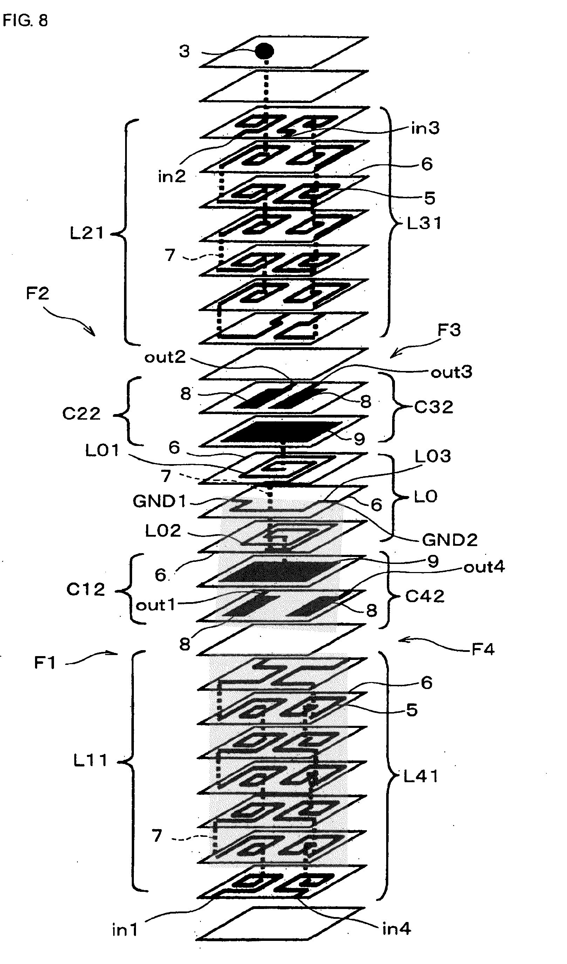

FIG. 8 is an exploded perspective view of a noise filter array according to an example not covered by invention. Note that in FIG. 8, portions assigned with the same reference signs as those in FIG. 1 to FIG. 4 are portions similar to or corresponding to the configuration of the first embodiment.

In the above first and second embodiments, the inductance adjusting conductor L0 is formed on the single insulating sheet 6, whereas in this example, inductance adjusting conductors L01 to L03 are formed spirally over a plurality of (three) insulating sheets 6, and these inductance adjusting conductors L01 to L03 are connected to one another through the via holes 7.

In the case of the noise filter array of this example as well, the inductance adjusting conductor L03 located in the middle is formed symmetrically with respect to a line or symmetrically with respect to a point, and the connection points with the via holes 7 are located at the center positions with respect to which the ground terminals GND1 and GND2 are point-symmetric.

According to the configuration of the noise filter array of this example, not only variations in characteristic among the filter elements F1 to F4 may be reduced but also large inductance values may be set for the LC series resonant circuits of the filter elements F1 to F4. Thus, it is possible to gain further low frequency. The other configuration, function and advantageous effects are similar to those of the first embodiment shown in FIG. 1 to FIG. 4, so detailed description thereof is omitted.

### Third Embodiment

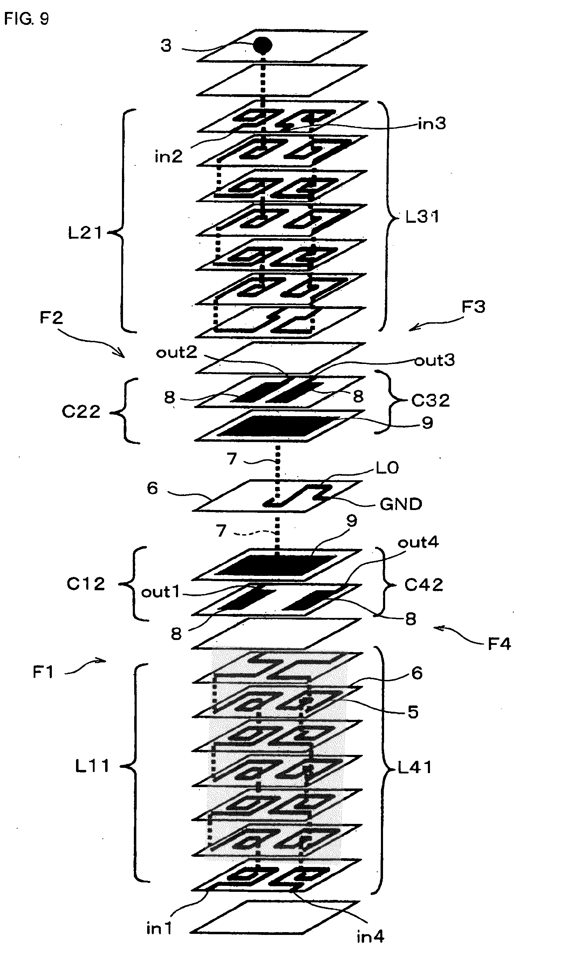

FIG. 9 is an exploded perspective view of a noise filter array according to a third embodiment of the invention. Note that in FIG. 9, portions assigned with the same reference signs as those in FIG. 1 to FIG. 4 are portions similar to or corresponding to the configuration of the first embodiment.

In the above first and second embodiments (and also in the example), the inductance adjusting conductor L0 (first and second embodiments) or L03 (example) is extended to the left and right ends of the insulating sheet 6 and connected to the external electrode 2 that forms two ground terminals GND1 and GND2, whereas in the third embodiment, one end of the inductance adjusting conductor L0 is connected to the via hole 7 and the other end is extended to one-side end of the insulating sheet 6 and connected to the external electrode that forms a single ground terminal GND.

In the case of the configuration of the third embodiment, plating adhesion is somewhat reduced when the inductance adjusting conductor L0 is formed by electrolytic plating; however, the distances from the ground-side electrodes 9 of the capacitors C22 and C32 and the capacitors C12 and C42 that constitute the LC series resonant circuits to the ground terminal GND through the via holes 7 and the inductance adjusting conductor L0 all are equal among the filter elements F1 to F4. Thus, variations in inductance value among the filter elements F1 to F4 are reduced. The other configuration, function and advantageous effects are similar to those of the first embodiment shown in FIG. 1 to FIG. 4, so detailed description thereof is omitted to avoid overlaps.

### Fourth Embodiment

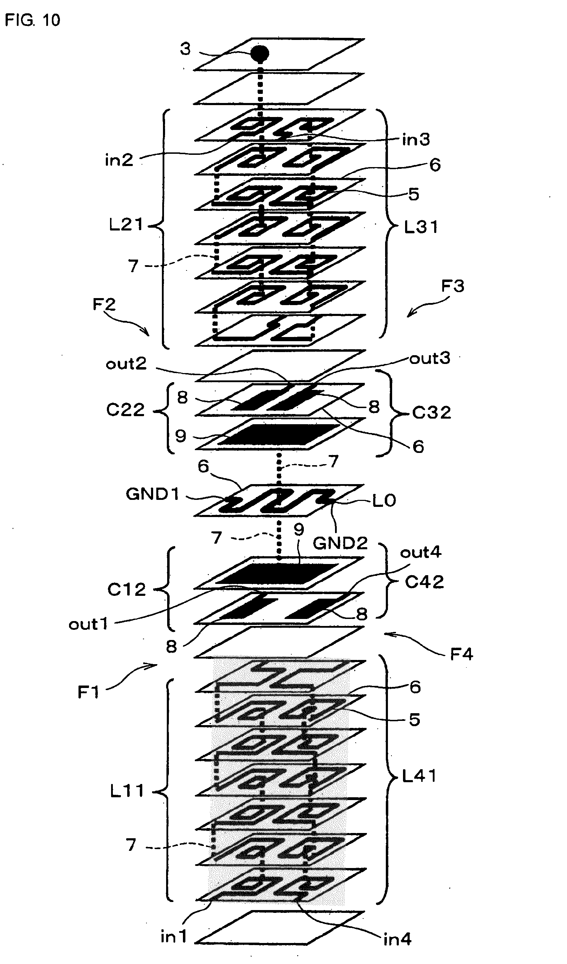

FIG. 10 is an exploded perspective view of a noise filter array according to a fourth embodiment of the invention. Note that in FIG. 10, portions assigned with the same reference signs as those in FIG. 1 to FIG. 4 are portions similar to or corresponding to the configuration of the first embodiment.

In the above first and second embodiments (and also the example), the via hole 7 is connected at the center of the inductance adjusting conductor L0 connected to the external electrodes 2 that form two ground terminals GND1 and GND2, whereas in the fourth embodiment, two via holes 7 are formed. Then, the connection points between the inductance adjusting conductor L0 and the via holes 7 are spaced equidistantly away from the center of symmetry of the left and right ground terminals GND1 and GND2.

Thus, in the case of the fourth embodiment as well, reliable electrical connection is established between the ground-side electrodes 9 of the capacitors C12 to C42 and the inductance adjusting conductor L0, and then the inductance values may be made equal among the filter elements F1 to F4. Thus, it is possible to reduce variations in filter characteristic. The other configuration, function and advantageous effects are similar to those of the first embodiment shown in FIG. 1 to FIG. 4, so detailed description thereof is omitted to avoid overlaps.

### Fifth Embodiment

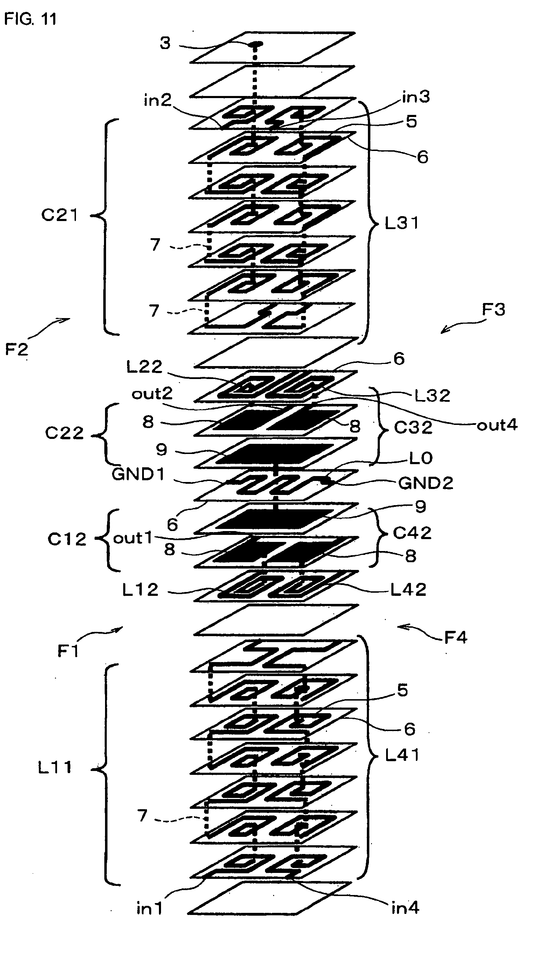

FIG. 11 is an exploded perspective view of a noise filter array according to a fifth embodiment of the invention. Note that in FIG. 11, portions assigned with the same reference signs as those in FIG. 1 to FIG. 4 are portions similar to or corresponding to the configuration of the first embodiment.

In the above first to fourth embodiments, the inductance adjusting conductor L0 is provided at a position placed between the upper and lower ground-side electrodes 9 that constitute the grounding capacitors C12 to C42, whereas in the fifth embodiment, inductance adjusting conductors L12 to L42 are separately provided respectively for the signal-side electrodes 8 of these grounding capacitors C12 to C42, and the signal-side electrodes 8 are electrically connected respectively to the inductance adjusting conductors L12 to L42 through the via holes 7.

As in the case of the fifth embodiment, when the inductance adjusting conductors L12 to L42 are also arranged on the sides of the signal-side electrodes 8 of the grounding capacitors C12 to C42 that constitute the LC series resonant circuits, the inductance values of the LC series resonant circuits of the filter elements F1 to F4 may be set so as to be larger than the case in which the single inductance adjusting conductor L0 is provided. Thus, it is possible to gain a further low frequency in each resonant circuit. In addition, the inductance values of the individual filter elements F1 to F4 may be set separately. The other configuration, function and advantageous effects are similar to those of the first embodiment shown in FIG. 1 to FIG. 4, so detailed description thereof is omitted to avoid overlaps.

### Sixth Embodiment

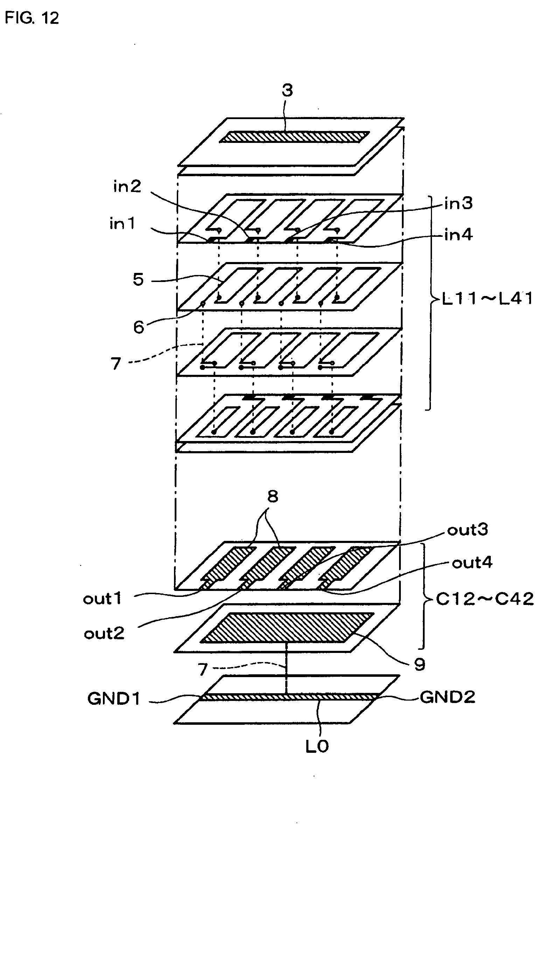

FIG. 12 is an exploded perspective view of a noise filter array according to a sixth embodiment of the invention. Note that in FIG. 12, portions assigned with the same reference signs as those in FIG. 1 to FIG. 4 are portions similar to or corresponding to the configuration of the first embodiment.

In the first to fifth embodiments, two filter elements F2 and F3 and two filter elements F1 and F4 are arranged respectively on both sides of the inductance adjusting conductor L0 in the thickness direction (laminated direction), whereas in the noise filter array of the sixth embodiment, the filter elements F1 to F4 are provided only on one side of the inductance adjusting conductor L0, that is, in FIG. 12, only on the upper side in the laminated direction than the layer in which the inductance adjusting conductor L0 is arranged. That is, the filter elements F1 to F4 are arranged parallel to one another in a direction perpendicular to the thickness direction of the component.

In the noise filter array of the sixth embodiment, because the filter elements F1 to F4 all are arranged parallel to one another, magnetic flux distributions that arise in the coils L11 to L41 of the filter elements F1 to F4 are somewhat different from one another and, therefore, variations in inductance value easily arise among the filter elements F1 to F4. However, the plurality of filter elements F1 to F4 are provided only on one side of the inductance adjusting conductor L0, so the thickness of the component may be reduced as compared with the first to fifth embodiments. The other configuration, function and advantageous effects are similar to those of the first embodiment shown in FIG. 1 to FIG. 4, so detailed description thereof is omitted to avoid overlaps.

Note that in the first to sixth embodiments, the case in which the individual component shown in FIG. 1 is separately produced is described. In the case of volume production, a mother laminated body that integrates a plurality of laminated bodies is manufactured, and then the mother laminated body is cut to obtain the laminated body 1 shown in FIG. 1, thus making it possible to obtain individual components.

In addition, in the first to sixth embodiments, the case in which the coil conductors 5, the signal-side electrodes 8, the ground-side electrodes 9, the via holes 7, and the like, are provided on the insulating sheets 6, and the insulating sheets 6 are laminated and then integrally fired is described. Instead, pre-fired insulating sheets 6 are used and, after that, the insulating sheets 6 are laminated and pressure-bonded to thereby make it possible to obtain the laminated body 1.

Furthermore, after an insulating layer is formed by applying a paste insulating material through a method such as printing, a paste conductive material is applied on the insulating layer to thereby form the coil conductors 5, the signal-side electrodes 8, the ground-side electrodes 9, and at the same time, the via holes 7 are formed where necessary and subsequently a paste insulating material is applied thereon to form an insulating layer. In this way, forming an insulating layer by applying an insulating material and forming a conductor by applying a conductive material are sequentially repeated to perform overcoating. Thus, a noise filter array having a laminated structure may be manufactured.

In addition, in the first to sixth embodiments, the noise filter array that includes four filter elements F1 to F4 is described; however, the invention does not specifically limit the number of filter elements. The invention may be widely applied to a noise filter array that includes a plurality of filter elements.

In addition, in the noise filter array of the first to sixth embodiments, each of the filter elements F1 to F4 is formed of the LC parallel resonant circuit and the LC series resonant circuit; however, the invention is not limited to it. For example, it is applicable that a noise filter array is formed so that a plurality of ladder filter elements, such as n type or T type, are arranged parallel to one another in an array and integrally formed.

The invention is not limited to the above embodiments in terms of points other than the above, and various applications or modifications are possible without departing from the scope of the invention, the invention being defined in the claims.

### Industrial Applicability

According to the invention, it is possible to obtain a noise filter array that has less variations in characteristic among a plurality of filter elements with a simple structure. Thus, the noise filter array of the invention may be widely utilized, for example, in a cellular phone that uses multiple communication bands in application to a noise filter for removing noise in the multiple communication bands.

## Claims

1. A noise filter array that is formed so that a plurality of filter elements (F1-F4) are arranged parallel to one another in an array and integrally formed, the noise filter array having a laminated structure,
wherein each of the filter elements (F1-F4) includes an LC parallel resonant circuit (PR1-PR4) having a coil (L11-L41) and a capacitor (C11-C41), and a grounding capacitor (C12-C42),
wherein an inductance adjusting conductor (L0) is provided which serves as an inductance coil, and
wherein each of the filter elements (F1-F4) includes an LC series resonant circuit formed of the grounding capacitor (C12-C42) and the inductance adjusting conductor (L0) which is common to the grounding capacitors (C12-C42) of the filter elements (F1-F4),
**characterized in that**:
- a single common ground-side electrode (9) of the grounding capacitors (C12-C42) that respectively constitute the capacitors of the LC series resonant circuits of the filter elements (F1-F4) is arranged so as to face signal-side electrodes (8) of the grounding capacitors (C12-C42),
the single common ground-side electrode (9) is connected through a via hole to the inductance adjusting conductor (L0), and
the length of the inductance adjusting conductor (L0) from a connection position, at which the inductance adjusting conductor (L0) is connected to the via hole, to a ground terminal (GND,GND1,GND2) is equal among the filter elements (F1-F4).

2. A noise filter array that is formed so that four filter elements are arranged parallel to one another in an array and integrally formed, the noise filter array having a laminated structure,
wherein each of the filter elements (F1-F4) includes an LC parallel resonant circuit (PR1-PR4) having a coil (L11-L41) and a capacitor (C11-C41), and a grounding capacitor (C12-C42),
wherein an inductance adjusting conductor (L0) is provided which serves as an inductance coil, and
wherein each of the filter elements (F1-F4) includes an LC series resonant circuit formed of the grounding capacitor (C12-C42) and the inductance adjusting conductor (L0) which is common to the grounding capacitors (C12-C42) of the filter elements (F1-F4),
**characterized in that**:
a first common ground-side electrode (9) of first grounding capacitors (C12, C42) that respectively constitute the capacitors of the LC series resonant circuits of two of the four filter elements is arranged so as to face signal-side electrodes of the first grounding capacitors (C12, C42), and the first common ground-side electrode (9) is connected through a first via hole to the inductance adjusting conductor (L0),
a second common ground-side electrode (9) of second grounding capacitors (C22, C32) that respectively constitute the capacitors of the LC series resonant circuits of the other two of the four filter elements is arranged so as to face signal-side electrodes of the second grounding capacitors (C22, C32), and the second common ground-side electrode (9) is connected through a second via hole to the inductance adjusting conductor (L0),
the filter elements (F1-F4) are arranged on both sides of the inductance adjusting conductor (L0) in its laminated direction two by two, and
the lengths of the inductance adjusting conductor (L0) from a connection position, at which the inductance adjusting conductor (L0) is connected to the first and second via holes, to a ground terminal (GND1,GND2) are equal among the filter elements (F1-F4).

3. The noise filter array according to Claim 1 or 2, **characterized in that** the inductance adjusting conductor (L0) is a conductor having a meander shape or a linear shape and is formed symmetrically with respect to a point or symmetrically with respect to a line.

4. The noise filter array according to Claim 3, **characterized in that** a connection point, at which the inductance adjusting conductor (L0) is connected to the via hole, is located at a center position with respect to which each ground terminal is point-symmetric or line-symmetric.

5. The noise filter array according to Claim 3, **characterized in that** the ground terminals are formed at positions that are point-symmetric or line-symmetric, a plurality of the via holes are formed, and connection points, at which the inductance adjusting conductor (L0) is connected to the via holes, are spaced equidistantly away from a center position with respect to which the ground terminals are point-symmetric or line-symmetric.

6. The noise filter array according to Claim 1, characterized the filter elements (F1-F4) are provided only on one side of the inductance adjusting conductor (L0) in its laminated direction.

7. The noise filter array according to Claim 6, **characterized in that** the four filter elements (F1-F4) are arranged parallel to one another.

8. The noise filter array according to any one of Claims 1 to 7, **characterized in that** conductors for forming the coils (L0,L11-L41) that constitute the LC parallel resonant circuits (PR1-PR4) and the LC series resonant circuits are formed at positions that do not overlap one another in their thickness direction.

9. The noise filter array according to any one of Claims 1 to 8, **characterized in that** a further inductance adjusting conductor (L12-L42) is also provided on the side of the signal-side electrode (8) of the grounding capacitor C12-C42) of each of the LC series resonant circuits.

## Patentansprüche

1. Ein Rauschfilterarray, das so gebildet ist, dass eine Mehrzahl von Filterelementen (F1-F4) parallel zueinander in einem Array angeordnet und einstückig gebildet ist, wobei das Rauschfilterarray eine laminierte Struktur aufweist,
wobei jedes der Filterelemente (F1-F4) eine LC-Parallel-Resonanzschaltung (PR1-PR4) mit einer Spule (L11-L41) und einem Kondensator (C11-C41) und einen Erdungskondensator (C12-C42) beinhaltet,
wobei ein Induktivitätsanpassleiter (L0) vorgesehen ist, der als eine Induktivitätsspule dient, und
wobei jedes der Filterelemente (F1-F4) eine LC-Serien-Resonanzschaltung beinhaltet, die aus dem Erdungskondensator (C12-C42) und dem Induktivitätsanpassleiter (L0), der den Erdungskondensatoren (C12-C42) der Filterelemente (F1-F4) gemein ist, gebildet ist,
**dadurch gekennzeichnet, dass**:
eine einzelne gemeinsame masseseitige Elektrode (9) der Erdungskondensatoren (C12-C42), die jeweils die Kondensatoren der LC-Serien-Resonanzschaltungen der Filterelemente (F1-F4) bilden, so angeordnet ist, dass sie signalseitigen Elektroden (8) der Erdungskondensatoren (C12-C42) zugewandt ist,
die einzelne gemeinsame masseseitige Elektrode (9) durch ein Durchgangsloch mit dem Induktivitätsanpassleiter (L0) verbunden ist, und
die Länge des Induktivitätsanpassleiters (L0) von einer Verbindungsposition, an der der Induktivitätsanpassleiter (L0) mit dem Durchgangsloch verbunden ist, bis zu einem Masseanschluss (GND, GND1, GND2) unter den Filterelementen (F1-F4) gleich ist.

2. Ein Rauschfilterarray, das so gebildet ist, dass vier Filterelemente parallel zueinander in einem Array angeordnet und einstückig gebildet sind, wobei das Rauschfilterarray eine laminierte Struktur aufweist,
wobei jedes der Filterelemente (F1-F4) eine LC-Parallel-Resonanzschaltung (PR1-PR4) mit einer Spule (L11-L41) und einem Kondensator (C11-C41) und einen Erdungskondensator (C12-C42) beinhaltet,
wobei ein Induktivitätsanpassleiter (L0) vorgesehen ist, der als eine Induktivitätsspule dient, und
wobei jedes der Filterelemente (F1-F4) eine LC-Serien-Resonanzschaltung beinhaltet, die aus dem Erdungskondensator (C12-C42) und dem Induktivitätsanpassleiter (L0), der den Erdungskondensatoren (C12-C42) der Filterelemente (F1-F4) gemein ist, gebildet ist,
**dadurch gekennzeichnet, dass**:
eine erste gemeinsame masseseitige Elektrode (9) der ersten Erdungskondensatoren (C12-C42), die jeweils die Kondensatoren der LC-Serien-Resonanzschaltungen von zwei der vier Filterelemente bilden, so angeordnet ist, dass sie signalseitigen Elektroden der ersten Erdungskondensatoren (C12, C42) zugewandt ist, und die erste gemeinsame masseseitige Elektrode (9) durch ein erstes Durchgangsloch mit dem Induktivitätsanpassleiter (L0) verbunden ist,
eine zweite gemeinsame masseseitige Elektrode (9) der zweiten Erdungskondensatoren (C22, C32), die jeweils die Kondensatoren der LC-Serien-Resonanzschaltungen der anderen beiden der vier Filterelemente bilden, so angeordnet ist, dass sie signalseitigen Elektroden der zweiten Erdungskondensatoren (C22, C32) zugewandt ist, und die zweite gemeinsame masseseitige Elektrode (9) durch ein zweites Durchgangsloch mit dem Induktivitätsanpassleiter (L0) verbunden ist,
die Filterelemente (F1-F4) auf beiden Seiten des Induktivitätsanpassleiters (L0) in dessen laminierter Richtung als zwei mal zwei angeordnet sind, und
die Längen des Induktivitätsanpassleiters (L0) von einer Verbindungsposition, an der der Induktivitätsanpassleiter (L0) mit dem ersten und dem zweiten Durchgangsloch verbunden ist, bis zu einem Masseanschluss (GND1, GND2) unter den Filterelementen (F1-F4) gleich sind.

3. Das Rauschfilterarray gemäß Anspruch 1 oder 2, das **dadurch gekennzeichnet ist, dass** der Induktivitätsanpassleiter (L0) ein Leiter mit einer Mäanderform oder einer linearen Form ist und in Bezug auf einen Punkt symmetrisch oder in Bezug auf eine Linie symmetrisch gebildet ist.

4. Das Rauschfilterarray gemäß Anspruch 3, das **dadurch gekennzeichnet ist, dass** sich ein Verbindungspunkt, an dem der Induktivitätsanpassleiter (L0) mit dem Durchgangsloch verbunden ist, an einer Mittelposition befindet, in Bezug auf die jeder Masseanschluss punktsymmetrisch oder liniensymmetrisch ist.

5. Das Rauschfilterarray gemäß Anspruch 3, das **dadurch gekennzeichnet ist, dass** die Masseanschlüsse an Positionen gebildet sind, die punktsymmetrisch oder liniensymmetrisch sind, eine Mehrzahl der Durchgangslöcher gebildet ist und Verbindungspunkte, an denen der Induktivitätsanpassleiter (L0) mit den Durchgangslöchern verbunden ist, in gleichen Abständen von einer Mittelposition beabstandet sind, in Bezug auf die die Masseanschlüsse punktsymmetrisch oder liniensymmetrisch sind.

6. Das Rauschfilterarray gemäß Anspruch 1, das **dadurch gekennzeichnet ist, dass** die Filterelemente (F1-F4) nur auf einer Seite des Induktivitätsanpassleiters (L0) in dessen laminierter Richtung vorgesehen sind.

7. Das Rauschfilterarray gemäß Anspruch 6, das **dadurch gekennzeichnet ist, dass** die vier Filterelemente (F1-F4) parallel zueinander angeordnet sind.

8. Das Rauschfilterarray gemäß einem der Ansprüche 1 bis 7, das **dadurch gekennzeichnet ist, dass** Leiter zum Bilden der Spulen (L0, L11-L41), die die LC-Parallel-Resonanzschaltungen (PR1-PR4) und die LC-Serien-Resonanzschaltungen bilden, an Positionen gebildet sind, die einander in ihrer Dickenrichtung nicht überlappen.

9. Das Rauschfilterarray gemäß einem der Ansprüche 1 bis 8, das **dadurch gekennzeichnet ist, dass** ein weiterer Induktivitätsanpassleiter (L12-L42) auch auf der Seite der signalseitigen Elektrode (8) des Erdungskondensators (C12-C42) jeder der LC-Serienresonanzschaltungen vorgesehen ist.

## Revendications

1. Réseau de filtres antibruit qui est formé de sorte qu'une pluralité d'éléments de filtre (F1-F4) sont agencés parallèlement les uns aux autres selon un réseau et sont formés d'une seule pièce, le réseau de filtres antibruit possédant une structure stratifiée,
dans lequel chacun des éléments de filtre (F1-F4) comprend un circuit résonnant parallèle LC (PR1-PR4) possédant une bobine (L11-L41) et un condensateur (C11-C41), et un condensateur de masse (C12-C42),
dans lequel un conducteur de réglage d'inductance (L0) est prévu qui est utilisé en tant que bobine d'inductance, et
dans lequel chacun des éléments de filtre (F1-F4) comprend un circuit résonnant série LC constitué du condensateur de masse (C12-C42) et du conducteur de réglage d'inductance (L0) qui est commun aux condensateurs de masse (C12-C42) des éléments de filtre (F1-F4),
**caractérisé en ce que** :
une unique électrode côté masse commune (9) des condensateurs de masse (C12-C42) qui constituent respectivement les condensateurs des circuits résonnants séries LC des éléments de filtre (F1-F4) est agencée de manière à faire face aux électrodes côté signal (8) des condensateurs de masse (C12-C42),
l'unique électrode côté masse commune (9) est reliée par l'intermédiaire d'un trou traversant au conducteur de réglage d'inductance (L0), et
la longueur du conducteur de réglage d'inductance (L0) à partir d'une position de connexion, à laquelle le conducteur de réglage d'inductance (L0) est relié par l'intermédiaire du trou traversant à une borne de masse (GND, GND1, GND2), est égale entre les éléments de filtre (F1-F4).

2. Réseau de filtres antibruit qui est formé de sorte que quatre éléments de filtre sont agencés parallèlement l'un à l'autre selon un réseau et sont formés d'une seule pièce, le réseau de filtres antibruit possédant une structure stratifiée,
dans lequel chacun des éléments de filtre (F1-F4) comprend un circuit résonnant parallèle LC (PR1-PR4) possédant une bobine (L11-L41) et un condensateur (C11-C41), et un condensateur de masse (C12-C42),
dans lequel un conducteur de réglage d'inductance (L0) est prévu qui est utilisé en tant que bobine d'inductance, et
dans lequel chacun des éléments de filtre (F1-F4) comprend un circuit résonnant série LC constitué du condensateur de masse (C12-C42) et du conducteur de réglage d'inductance (L0) qui est commun aux condensateurs de masse (C12-C42) des éléments de filtre (F1-F4),
**caractérisé en ce que** :
une première électrode côté masse commune (9) des premiers condensateurs de masse (C12, C42) qui constituent respectivement les condensateurs des circuits résonnants séries LC de deux des quatre éléments de filtre est agencée de manière à faire face aux électrodes côté signal des premiers condensateurs de masse (C12, C42), et la première électrode côté masse commune (9) est reliée par l'intermédiaire d'un premier trou traversant au conducteur de réglage d'inductance (L0),
une seconde électrode côté masse commune (9) des seconds condensateurs de masse (C22, C32) qui constituent respectivement les condensateurs du circuit résonnant série LC des deux autres des quatre éléments de filtre est agencée de manière à faire face aux électrodes côté signal des seconds condensateurs de masse (C22, C32), et la seconde électrode côté masse commune (9) est reliée par l'intermédiaire d'un second trou traversant au conducteur de réglage d'inductance (L0),
les éléments de filtre (F1-F4) sont agencés sur les deux côtés du conducteur de réglage d'inductance (L0) dans sa direction stratifiée deux par deux, et
les longueurs du conducteur de réglage d'inductance (L0) à partir d'une position de connexion, à laquelle le conducteur de réglage d'inductance (L0) est relié aux premier et second trous traversants, à une borne de masse (GND1, GND2), sont égales entre les éléments de filtre (F1-F4).

3. Réseau de filtres antibruit selon la revendication 1 ou 2, **caractérisé en ce que** le conducteur de réglage d'inductance (L0) est un conducteur possédant une forme de méandre ou une forme linéaire et est formé symétriquement par rapport à un point ou symétriquement par rapport à une ligne.

4. Réseau de filtres antibruit selon la revendication 3, **caractérisé en ce qu'**un point de connexion, auquel le conducteur de réglage d'inductance (L0) est relié au trou traversant, est situé en une position centrale par rapport à laquelle chaque borne de masse est à symétrie ponctuelle ou à symétrie linéaire.

5. Réseau de filtres antibruit selon la revendication 3, **caractérisé en ce que** les bornes de masse sont formées en des positions qui sont à symétrie ponctuelle ou à symétrie linéaire, une pluralité de trous traversants sont formés, et des points de connexion, auxquels le conducteur de réglage d'inductance (L0) est relié aux trous traversants, sont espacés de manière équidistante d'une position centrale par rapport à laquelle les bornes de masse sont à symétrie ponctuelle ou à symétrie linéaire.

6. Réseau de filtres antibruit selon la revendication 1, **caractérisé en ce que** les éléments de filtre (F1-F4) sont prévus uniquement sur un côté du conducteur de réglage d'inductance (L0) dans sa direction stratifiée.

7. Réseau de filtres antibruit selon la revendication 6, **caractérisé en ce que** les quatre éléments de filtre (F1-F4) sont agencés parallèlement les uns aux autres.

8. Réseau de filtres antibruit selon l'une quelconque des revendications 1 à 7, **caractérisé en ce que** les conducteurs pour former les bobines (L0, L11-L41) qui constituent les circuits résonnants parallèles LC (PR1-PR4) et les circuits résonnants séries LC sont formés en des positions qui ne se recouvrent pas dans leur direction d'épaisseur.

9. Réseau de filtres antibruit selon l'une quelconque des revendications 1 à 8, **caractérisé en ce qu'**un autre conducteur de réglage d'inductance (L12-L42) est également prévu sur le côté de l'électrode côté signal (8) du condensateur de masse (C12-C42) de chacun des circuits résonnants séries LC.
